# EUROPÄISCHE PATENTSCHRIFT

(11) **EP 2 198 464 B1**
(45) Veröffentlichungstag und Bekanntmachung des Hinweises auf die Patenterteilung: **16.11.2016**
(21) Anmeldenummer: 08801255.4
(22) Anmeldetag: 28.08.2008
(51) Int. Cl.: H01L 33/44

(54) **STRAHLUNGSEMITTIERENDES BAUELEMENT**
RADIATION-EMITTING COMPONENT
COMPOSANT EMETTEUR DE RAYONNEMENT

(30) Priorität: 21.09.2007 DE 102007045087; 21.01.2008 DE 102008005344
(43) Veröffentlichungstag der Anmeldung: 23.06.2010
(73) Patentinhaber: OSRAM Opto Semiconductors GmbH, 93055 Regensburg (DE)
(72) Erfinder: GRÖTSCH, Stefan, 93077 Lengfeld-Bad Abbach (DE); MARFELD, Jan, 93055 Regensburg (DE); SORG, Jörg Erich, 93053 Regensburg (DE); ENGL, Moritz, 93055 Regensburg (DE); KÖHLER, Steffen, 93049 Regensburg (DE)
(74) Vertreter: Epping - Hermann - Fischer
(86) Internationale Anmeldenummer: PCT/DE2008/001448
(87) Internationale Veröffentlichungsnummer: WO 2009/036731

(56) Entgegenhaltungen:
- EP-A- 1 816 687
- WO-A-2004/100278
- FR-A- 2 861 853

## Beschreibung

Die vorliegende Erfindung betrifft ein strahlungsemittierendes Bauelement, das einen zur Emission elektromagnetischer Strahlung ausgebildeten aktiven Bereich aufweist.

Die Aufgabe der Erfindung ist es, ein strahlungsemittierendes Bauelement zu schaffen, mit dem in einfacher Weise ein hoher Strahlungsemissionswirkungsgrad des strahlungsemittierenden Bauelements ermöglicht ist. Zudem soll in einfacher Weise ein gewünschtes Strahlungsspektrum mit möglichst hoher Genauigkeit realisiert werden.

In der Druckschrift WO 2004/100278 A2 ist ein Licht emittierendes Bauteil mit einer Antireflexionsschicht angegeben.

Die Druckschrift EP 1 816 687 A2 betrifft ein Halbleiterbauteil und eine Herstellungsmethode hierfür.

Ein brechungsindexangepasstes Substrat ist in der Druckschrift FR 2 861 853 A1 beschrieben.

Die Aufgabe wird gelöst durch die Merkmale des unabhängigen Patentanspruchs . Vorteilhafte Ausgestaltungen der Erfindung sind in den Unteransprüchen gekennzeichnet.

Es wird ein strahlungsemittierendes Bauelement angegeben, das aufweist einen Halbleiterschichtenstapel mit einem aktiven Bereich, der zur Emission elektromagnetischer Strahlung ausgebildet ist, und mindestens eine Oberfläche des Halbleiterschichtenstapels oder eines zur Transmission der elektromagnetischen Strahlung ausgebildeten optischen Elements, wobei die Oberfläche einen Normalenvektor hat, wobei auf der mindestens einen Oberfläche des Halbleiterschichtenstapel oder des optischen Elements, durch die die elektromagnetische Strahlung hindurch tritt, eine Antireflexionsschicht angeordnet und derart ausgebildet ist, dass sie für eine vorgegebene Wellenlänge eine minimale Reflexion unter einem auf den Normalenvektor der Oberfläche bezogenen Betrachtungswinkel aufweist, bei dem die Zunahme eines zonalen Lichtflusses der elektromagnetischen Strahlung in etwa ein Maximum aufweist. Der zonale Lichtfluss ist der Lichtfluss in einem Raumwinkelbereich über der Oberfläche des Halbleiterschichtenstapels oder über der Oberfläche des zur Transmission der elektromagnetischen Strahlung ausgebildeten optischen Elements, ausgehend von dem Normalenvektor der jeweiligen Oberfläche.

Der zonale Lichtfluss in dem Raumwinkelbereich über der Oberfläche des Halbleiterschichtenstapels oder über der Oberfläche des zur Transmission der elektromagnetischen Strahlung ausgebildeten optischen Elements erlaubt eine Aussage zur winkelabhängigen Gesamtemission des strahlungsemittierenden Bauelements. Der Vorteil einer Ausbildung der Antireflexionsschicht derart, dass sie für eine vorgegebene Wellenlänge eine minimale Reflexion unter einem auf den Normalenvektor der Oberfläche bezogenen Betrachtungswinkel aufweist, bei dem die Zunahme eines zonalen Lichtflusses der elektromagnetischen Strahlung in etwa ein Maximum aufweist, besteht darin, dass so eine Maximierung der Gesamtemission für strahlungsemittierende Bauelemente unter Berücksichtung des Verlaufs des zonalen Lichtflusses der elektromagnetischen Strahlung abhängig vom Betrachtungswinkel möglich ist.

Die Antireflexionsschicht ist derart ausgebildet, dass sie für die vorgegebene Wellenlänge die minimale Reflexion unter dem auf den Normalenvektor bezogenen Betrachtungswinkel zwischen 30° und 60° aufweist. Damit ist eine Maximierung der Gesamtemission für strahlungsemittierende Bauelemente möglich, bei denen das Maximum der Zunahme des zonalen Lichtflusses (der integrierten Lichtfluss-Winkelverteilung) der elektromagnetischen Strahlung bei Betrachtungswinkeln zwischen 30° und 60° liegt.

In einer weiteren bevorzugten Ausführungsform ist die Antireflexionsschicht derart ausgebildet ist, dass sie für die vorgegebene Wellenlänge unter dem auf den Normalenvektor bezogenen Betrachtungswinkel zwischen 40° und 50° die minimale Reflexion aufweist. Damit ist eine Maximierung der Gesamtemission für strahlungsemittierende Bauelemente möglich, bei denen das Maximum der Zunahme des zonalen Lichtflusses der elektromagnetischen Strahlung bei einem Betrachtungswinkel von ca. 45° liegt.

In einer weiteren Ausführungsform hat das strahlungsemittierende Bauelement ein Substrat, auf dem der Halbleiterschichtenstapel angeordnet ist, und das eine von dem Halbleiterschichtenstapel abgewandte Oberfläche hat, auf der die Antireflexionsschicht angeordnet ist. Dies hat den Vorteil, dass die Antireflexionsschicht einfach auf das bestehende Substrat des strahlungsemittierenden Bauelements aufgebracht werden kann.

In einer weiteren Ausführungsform weist das strahlungsemittierende Bauelement eine Deckplatte auf, die von dem Halbleiterschichtenstapel beabstandet ist, wobei die Deckplatte eine dem Halbleiterschichtenstapel zugewandte Oberfläche und eine von dem Halbleiterschichtenstapel abgewandte Oberfläche aufweist, und die Antireflexionsschicht auf mindestens einer der Oberflächen der Deckplatte angeordnet ist. Damit kann das Aufbringen der Reflexionsschicht in vorteilhafter Weise unabhängig von der Herstellung des Halbleiterschichtenstapels erfolgen. Die Reflexionsschicht kann abschließend auch auf das bereits fertig gestellte strahlungsemittierende Bauelement aufgebracht werden.

In einer weiteren Ausführungsform umfasst die Antireflexionsschicht ein Metallfluorid oder ein Metalloxid, und das Metall ist aus der Gruppe aus Hafnium, Zirkon, Aluminium, Titan und Magnesium ausgewählt. Dies hat den Vorteil, dass sich Metallfluoride und Metalloxide mit derartigen Metallen sehr gut für Antireflexionsschichten eignen.

In einer weiteren Ausführungsform umfasst das Substrat ein Material, das aus der Gruppe von Glas, Quarz und Kunststoff ausgewählt ist. Damit ist eine stabile, einfach herstellbare und kostengünstige Lösung für das Substrat möglich.

Gemäß einer Abwandlung wird ein strahlungsemittierendes Bauelement angegeben, das aufweist einen Halbleiterschichtenstapel mit einem aktiven Bereich, der zur Emission elektromagnetischer Primärstrahlung ausgebildet ist, und eine mit dem Halbleiterschichtenstapel mechanisch gekoppelte Konverterschicht, die einen Leuchtstoff aufweist, der ausgebildet ist zur Konversion eines Teils der elektromagnetischen Primärstrahlung in eine elektromagnetische Sekundärstrahlung, wobei sich ein Teil der elektromagnetischen Primärstrahlung mit einem Teil der elektromagnetischen Sekundärstrahlung zu einer Mischstrahlung mit einem resultierenden Farbort überlagert, und auf mindestens einer der Oberflächen, durch die die elektromagnetische Mischstrahlung hindurch tritt, eine Farbkorrekturschicht mit mindestens zwei benachbart angeordneten Schichten angeordnet ist, wobei eine erste Schicht aus einem Material mit einem ersten Brechungsindex und eine zweite Schicht aus einem Material mit einem zweiten Brechungsindex besteht, der erste Brechungsindex von dem zweiten Brechungsindex verschieden ist und die Schichten zur Einstellung des resultierenden Farborts abhängig von einem Betrachtungswinkel ausgebildet sind.

Dies hat den Vorteil, dass unter Berücksichtung der Zusammensetzung der elektromagnetischen Mischstrahlung eine sehr differenzierte Beeinflussung des Mischungsverhältnisses von Primär- und Sekundärstrahlung für strahlungsemittierende Bauelemente abhängig vom Betrachtungswinkel möglich ist. Des weiteren hat dies den Vorteil, dass elektromagnetischen Strahlung einer Wellenlänge, die nicht emittiert werden soll, in die Konverterschicht zurückreflektiert werden kann, und dort zur weiteren Nutzung in elektromagnetische Sekundärstrahlung konvertiert werden kann.

In einer Abwandlung ist die Farbkorrekturschicht als Schichtenstapel mit einer Vielzahl von Schichten ausgebildet, und die Schichten sind so angeordnet sind, dass die beiden jeweils einer der Schichten benachbarten Schichten Brechungsindizes aufweisen, die beide entweder kleiner oder größer als der Brechungsindex der jeweiligen einen Schicht sind. Dies entspricht einer Anordnung eines Schichtenstapels mit Schichten mit abwechselnd hohem und niedrigem Brechungsindex. Durch eine derartige Anordnung der Schichten ist eine breitbandige und hochwirksame Farbkorrektur ermöglicht.

In einer Abwandlung ist die Farbkorrekturschicht auf der Konverterschicht angeordnet. Damit kann die Farbkorrekturschicht so angeordnet werden, dass sie mechanisch besonders gut geschützt ist.

In einer Abwandlung hat das strahlungsemittierende Bauelement eine Deckplatte, die auf der Konverterschicht angeordnet ist, und die eine von der Konverterschicht abgewandte Oberfläche hat, auf der die Farbkorrekturschicht angeordnet ist. Damit kann ein Aufbringen der Farbkorrekturschicht unabhängig von der Herstellung des Schichtenstapels und der Konverterschicht erfolgen. Die Reflexionsschicht kann abschließend auch auf die Deckplatte des bereits fertig gestellten strahlungsemittierenden Bauelements aufgebracht werden.

In einer Abwandlung weist das strahlungsemittierende Bauelement eine Deckplatte auf, die von der Konverterschicht beabstandet ist, wobei die Deckplatte eine dem Halbleiterschichtenstapel zugewandte Oberfläche und eine von dem Halbleiterschichtenstapel abgewandte Oberfläche aufweist, und die Farbkorrekturschicht auf mindestens einer der Oberflächen der Deckplatte angeordnet ist. Dies hat den Vorteil, dass das Aufbringen der Farbkorrekturschicht unabhängig von der Herstellung des Schichtenstapels und der Konverterschicht erfolgen kann. Die Reflexionsschicht kann auch abschließend auf eine separate Deckplatte des ansonsten bereits fertig gestellten strahlungsemittierenden Bauelements aufgebracht werden.

In einer Abwandlung umfasst die Farbkorrekturschicht ein Metallfluorid oder ein Metalloxid, und das Metall ist aus der Gruppe aus Magnesium, Hafnium, Zirkon, Aluminium und Titan ausgewählt. Die Schichten der Farbkorrekturschicht können aus verschiedenen Metallfluoriden und Metalloxiden gebildet sein. Metallfluoride und Metalloxide mit derartigen Metallen eignen sich sehr gut für Schichten zur Farbkorrektur.

Gemäß einer weiteren Abwandlung wird ein strahlungsemittierendes Bauelement angegeben, das aufweist einen Halbleiterschichtenstapel mit einem aktiven Bereich, der zur Emission elektromagnetischer Strahlung ausgebildet ist, und ein Abdeckelement mit einer Oberfläche, wobei in einem ersten Abschnitt des Abdeckelements auf der Oberfläche eine absorbierende oder reflektierende Schicht angeordnet ist und in einem zweiten Abschnitt des Abdeckelements die Oberfläche frei von der absorbierenden oder reflektierenden Schicht ist. Dies hat den Vorteil, dass das strahlungsemittierende Bauelement mit Halbleiterschichtenstapel einen Lichtstrahl mit einer Querschnittsform aussenden kann, der durch die Form des als Fensterbereich ausgebildeten zweiten Abschnitts des Abdeckelements festgelegt ist.

In einer Abwandlung ist auf einer der Oberflächen des zweiten Abschnitts des Abdeckelements eine Antireflexionsschicht angeordnet und derart ausgebildet ist, dass sie für eine vorgegebene Wellenlänge eine minimale Reflexion unter einem auf einen Normalenvektor der Oberfläche bezogenen Betrachtungswinkel aufweist, bei dem die Zunahme eines zonalen Lichtflusses der elektromagnetischen Strahlung in etwa ein Maximum aufweist. Damit ist es möglich, dass die Gesamtemission für das strahlungsemittierende Bauelement im als Fensterbereich ausgebildeten zweiten Abschnitt des Abdeckelements unter Berücksichtung des Verlaufs des zonalen Lichtflusses der elektromagnetischen Strahlung abhängig vom Betrachtungswinkel ein Maximum annimmt.

In einer weiteren Abwandlung ist die Antireflexionsschicht derart ausgebildet, dass sie für die vorgegebene Wellenlänge unter dem Betrachtungswinkel zwischen 40° und 50° eine minimale Reflexion aufweist. Dies hat den Vorteil, dass die Gesamtemission des strahlungsemittierenden Bauelements, bei dem das Maximum der Zunahme des zonalen Lichtflusses der elektromagnetischen Strahlung bei einem Betrachtungswinkel von ca. 45° liegt, ein Maximum annehmen kann.

In einer weiteren Abwandlung umfasst die Antireflexionsschicht ein Metallfluorid oder ein Metalloxid, und das Metall ist aus der Gruppe aus Hafnium, Zirkon, Aluminium, Titan und Magnesium ausgewählt ist. Dies ist besonders vorteilhaft, da Metallfluoride und Metalloxide mit derartigen Metallen sehr gut für Antireflexionsschichten geeignet sein können.

In einer weiteren Abwandlung ist die elektromagnetische Strahlung eine elektromagnetische Primärstrahlung, und mit einer mit dem Schichtenstapel mechanisch gekoppelten Konverterschicht, die einen Leuchtstoff aufweist, der ausgebildet ist zur Konversion eines Teils der elektromagnetischen Primärstrahlung in eine elektromagnetische Sekundärstrahlung, wobei sich ein Teil der elektromagnetischen Primärstrahlung mit einem Teil der elektromagnetischen Sekundärstrahlung zu einer Mischstrahlung mit einem resultierenden Farbort überlagert, und wobei auf dem zweiten Abschnitt des Abdeckelements angeordnet ist eine Farbkorrekturschicht mit mindestens zwei benachbart angeordneten Schichten angeordnet, wobei eine erste Schicht aus einem Material mit einem ersten Brechungsindex und eine zweite Schicht aus einem Material mit einem zweiten Brechungsindex besteht, der erste Brechungsindex von dem zweiten Brechungsindex verschieden ist und die Schichten zur Einstellung des resultierenden Farborts abhängig von einem Betrachtungswinkel ausgebildet sind. Dies hat den Vorteil, dass unter Berücksichtung der Zusammensetzung der elektromagnetischen Mischstrahlung eine sehr differenzierte Beeinflussung des Mischungsverhältnisses von Primär- und Sekundärstrahlung für strahlungsemittierende Bauelemente abhängig vom Betrachtungswinkel möglich ist.

In einer weiteren Abwandlung umfasst die Farbkorrekturschicht ein Metallfluorid oder ein Metalloxid, und das Metall ist aus der Gruppe aus Magnesium, Hafnium, Zirkon, Aluminium und Titan ausgewählt. Dies ist vorteilhaft, da Metallfluoride und Metalloxide mit derartigen Metallen sich sehr gut für Schichten zur Farbkorrektur eignen.

In einer weiteren Abwandlung ist die Farbkorrekturschicht als Schichtenstapel mit einer Vielzahl von Schichten ausgebildet, und die Schichten sind so angeordnet, dass die beiden jeweils einer der Schichten benachbarten Schichten Brechungsindizes aufweisen, die beide entweder kleiner oder größer als der Brechungsindex der jeweiligen Schicht. Dies ist vorteilhaft, da Schichtenstapel mit abwechselnd hohen und niedrigen Brechungsindizes eine breitbandige und hochwirksame Farbkorrektur ermöglichen.

In einer weiteren Abwandlung sind die Antireflexionsschicht und die Farbkorrekturschicht auf zwei einander entgegengesetzt angeordneten Oberflächen des zweiten Abschnitts des Abdeckelements angeordnet. Dies hat den Vorteil, dass das Abdeckelement als Träger sowohl für die Antireflexionsschicht als auch die Farbkorrekturschicht dienen kann. Des Weiteren hat dies den Vorteil, dass die Antireflexionsschicht unabhängig von der Farbkorrekturschicht auf das Abdeckelement aufgebracht werden kann.

In einer weiteren Ausführungsform ist das strahlungsemittierende Bauelement eine Leuchtdiode. Damit ist es möglich, die Reflexionsschicht und/oder die Farbkorrekturschicht für Leuchtdioden einzusetzen.

In einer weiteren Ausführungsform ist das strahlungsemittierende Bauelement flächenförmig ausgebildet. Dabei kann flächenförmig ausgebildet bedeuten, dass sich das strahlungsemittierende Bauelement zusammenhängend über einen Flächenbereich erstreckt, der zumindest eine Fläche von mehreren Quadratmillimetern, bevorzugt mehreren Quadratzentimetern und besonders bevorzugt zumindest einem oder mehreren Quadratdezimetern oder mehr aufweist. Dies hat den Vorteil, dass die Reflexionsschicht und/oder die Farbkorrekturschicht für flächenförmig ausgebildete strahlungsemittierende Bauelemente und damit auch für sehr flache strahlungsemittierende Bauelemente ausgebildet werden kann.

Vorteilhafte Ausgestaltungen der Erfindung sind nachfolgend anhand der schematischen Zeichnungen näher erläutert.

Es zeigen:
- Figur 1: eine Schnittansicht einer ersten Ausführungsform einer strahlungsemittierenden Vorrichtung mit einer Antireflexionsschicht,
- Figur 2: eine Schnittansicht einer weiteren Ausführungsform der strahlungsemittierenden Vorrichtung mit einer Antireflexionsschicht,
- Figur 3: eine Schnittansicht einer weiteren Ausführungsform einer strahlungsemittierenden Vorrichtung mit einer Antireflexionsschicht,
- Figur 4: eine Schnittansicht einer ersten Abwandlung einer strahlungsemittierenden Vorrichtung mit einer Farbkorrekturschicht,
- Figur 5: eine Schnittansicht einer weiteren Abwandlung der strahlungsemittierenden Vorrichtung mit einer Farbkorrekturschicht,
- Figur 6: eine Schnittansicht einer weiteren Abwandlung der strahlungsemittierenden Vorrichtung mit einer Farbkorrekturschicht,
- Figur 7: eine Schnittansicht einer Abwandlung einer strahlungsemittierenden Vorrichtung,
- Figur 8: eine Aufsicht auf die weitere Abwandlung der strahlungsemittierenden Vorrichtung entlang der Linie VI-II-VIII' der Figur 7,
- Figur 9: eine Schnittansicht einer Farbkorrekturschicht der Abwandlung der strahlungsemittierenden Vorrichtung,
- Figur 10: Farbortkoordinaten einer strahlungsemittierenden Vorrichtung gemäß einer CIE-Farbtafel in Abhängigkeit von einem Betrachtungswinkel,
- Figur 11: die CIE-Farbtafel mit ausgewählten Farborten, und
- Figur 12: ein Verlauf eines zonalen Lichtflusses einer Leuchtdiode in normierter Darstellung.

Elemente gleicher Konstruktion oder Funktion sind figurenübergreifend mit den gleichen Bezugszeichen gekennzeichnet. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche zur besseren Darstellbarkeit und/oder zum besseren Verständnis übertrieben dick oder groß dimensioniert dargestellt sein.

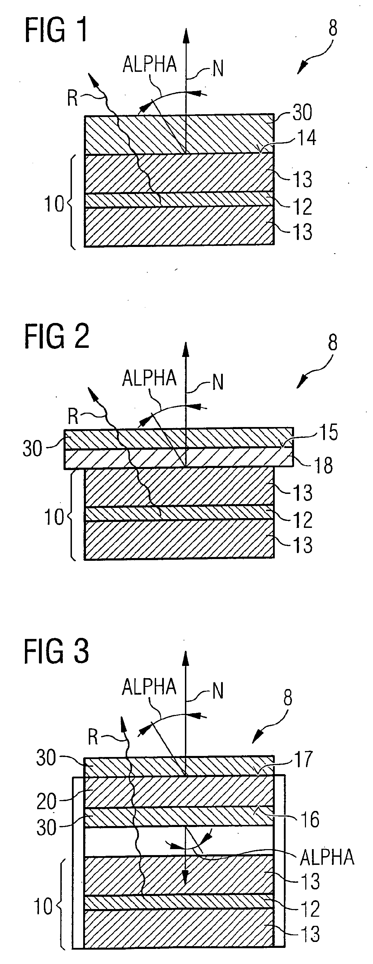

In Figur 1 ist ein erstes Ausführungsbeispiel für ein strahlungsemittierendes Bauelement 8 gezeigt.

Das strahlungsemittierende Bauelement 8 weist einen Halbleiterschichtenstapel 10 auf. Der Halbleiterschichtenstapel 10 hat einen zur Emission elektromagnetischer Strahlung R ausgebildeten aktiven Bereich 12.

Derartige strahlungsemittierende Bauelemente 8 sind bevorzugt so ausgebildet, dass das strahlungsemittierende Bauelement 8 eine Leuchtdiode oder ein Leuchtdiodenarray ist.

Bevorzugt ist das strahlungsemittierende Bauelement 8 eine Halbleiterleuchtdiode, beispielsweise auf der Basis von AlIn-GaN.

Benachbart zu dem aktiven Bereich 12 sind Anschlussbereiche 13 angeordnet, die mit Anschlussdrähten zur Versorgung des strahlungsemittierenden Bauelements 8 mit elektrischem Strom gekoppelt sind.

Der Halbleiterschichtenstapel 10 ist auf einem Substrat 18 angeordnet. Besonders bevorzugt ist, wenn das Substrat 18 Glas aufweist. Alternativ oder zusätzlich kann das Substrat 18 auch Quarz, Kunststofffolien, Metall, Metallfolien, Siliziumwafer oder ein beliebiges anderes geeignetes Substratmaterial umfassen. Alternativ oder zusätzlich kann das Substrat 18 auch ein Laminat oder eine Schichtenfolge aus mehreren Schichten aufweisen. Dabei kann zumindest eine der Schichten Glas aufweisen oder aus Glas sein. Insbesondere kann bei einem aus einer Schichtenfolge gebildeten Substrat 18 zumindest die Schicht Glas aufweisen, auf der der Halbleiterschichtenstapel 10 angeordnet ist. Darüber hinaus kann das Substrat 18 auch Kunststoff aufweisen.

Ist das strahlungsemittierende Bauelement 8 derart ausgebildet, dass die in dem aktiven Bereich 12 emittierte elektromagnetische Strahlung R durch das Substrat 18 hindurch abgestrahlt wird (Figur 2), so kann das Substrat 18 vorteilhafterweise eine Transparenz für zumindest einen Teil der im aktiven Bereich 12 erzeugten elektromagnetischen Strahlung aufweisen. In dieser Konfiguration kann vorteilhafterweise auch der zwischen dem aktiven Bereich 12 und dem Substrat 18 ausgebildete Anschlussbereich 13 eine Transparenz zumindest für einen Teil der im aktiven Bereich 12 erzeugten elektromagnetischen Strahlung aufweisen.

Der Halbleiterschichtenstapel 10 hat eine Oberfläche 14 mit einem Normalenvektor N, auf der eine Antireflexionsschicht 30 angeordnet ist (Figur 1). Diese Antireflexionsschicht 30 ist derart ausgebildet, dass sie für eine vorgegebene Wellenlänge eine minimale Reflexion unter einem auf den Normalenvektor N der Oberfläche 14 des Halbleiterschichtenstapels 10 bezogenen Betrachtungswinkels ALPHA aufweist, bei dem die Zunahme eines zonalen Lichtflusses der elektromagnetischen Strahlung R in etwa ein Maximum aufweist.

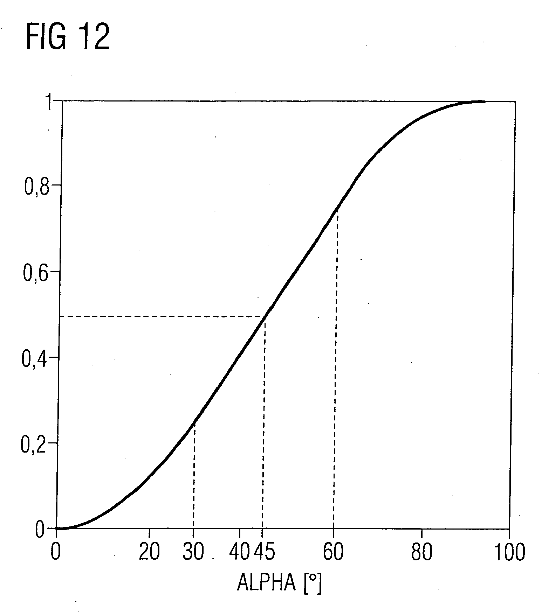

Der Verlauf des zonalen Lichtflusses ist beispielhaft für eine Leuchtdiode in Figur 12 in normierter Form dargestellt. Die Darstellung erfolgt in Abhängigkeit von einem Raumwinkelbereich zwischen 0° und dem Betrachtungswinkel ALPHA. Der Raumwinkelbereich geht jeweils von dem Normalenvektor N aus und der Betrachtungswinkel ALPHA kann zwischen 0° und 90° liegen. Der zonale Lichtfluss ist dabei auf den zonalen Lichtfluss in einem Raumwinkelbereich zwischen 0° und 90° normiert. In der hier dargestellten Ausführungsform des strahlungsemittierenden Bauelements 8 als Leuchtdiode wird der maximale Anstieg des zonalen Lichtflusses für einen Wert des Betrachtungswinkels ALPHA gleich 45° erreicht. Anders ausgedrückt bedeutet dies, dass der höchste differentielle Beitrag zur Gesamtemission der Leuchtdiode bei einem Raumwinkel liegt, für den der Betrachtungswinkel ALPHA gleich 45° ist.

Die Antireflexionsschicht 30 muss nicht zwingend derart ausgebildet sein, dass für die vorgegebene Wellenlänge die Reflexion genau unter dem auf den Normalenvektor N der Oberfläche 14 bezogenen Betrachtungswinkel ALPHA minimal ist, da die Zunahme des zonalen Lichtflusses der elektromagnetischen Strahlung R in der Regel in einem breiten Bereich um das Maximum der Zunahme des zonalen Lichtflusses der elektromagnetischen Strahlung R herum annähernd konstant ist. Es ist deshalb ausreichend, wenn die Antireflexionsschicht 30 derart ausgebildet ist, dass für die vorgegebene Wellenlänge der minimale Reflexion unter einem auf den Normalenvektor N der Oberfläche 14 bezogenen Betrachtungswinkel ALPHA in der Nähe des Maximums der Zunahme des zonalen Lichtflusses der elektromagnetischen Strahlung R liegt.

Es liegt für die vorgegebene Wellenlänge die minimale Reflexion der Antireflexionsschicht 30 unter dem auf den Normalenvektor N bezogenen Betrachtungswinkel ALPHA zwischen 30° und 60° liegt. Es ist so möglich, für strahlungsemittierende Bauelemente 8 eine Maximierung der Gesamtemission zu erreichen, für die das Maximum des zonalen Lichtflusses der elektromagnetischen Strahlung R bei Betrachtungswinkeln ALPHA zwischen 30° und 60° liegt.

Besonders bevorzugt ist insbesondere, wenn die minimale Reflexion der Antireflexionsschicht 30 für die vorgegebene Wellenlänge in einem Bereich des Betrachtungswinkels ALPHA zwischen 40° und 50° liegt.

In einer weiteren Ausführungsform weist das Substrat 18 eine Oberfläche 15 auf, die von dem Halbleiterschichtenstapel 10 abgewandt ist (Figur 2). Auf der von dem Halbleiterschichtenstapel 10 abgewandten Oberfläche 15 des Substrats 18 ist die Antireflexionsschicht 30 angeordnet. Die Funktion der Antireflexionsschicht 30 der Ausführungsform der Figur 2 entspricht der Funktion der Antireflexionsschicht 30 der Ausführungsform der Figur 1.

Figur 3 zeigt das strahlungsemittierende Bauelement mit dem Halbleiterschichtenstapel 10 und einer von dem Halbleiterschichtenstapel 10 beabstandeten Deckplatte 20, die eine dem Halbleiterschichtenstapel 10 zugewandte Oberfläche 16 und eine von dem Halbleiterschichtenstapel 10 abgewandte Oberfläche 17 aufweist. Um eine Reduzierung der Reflexion an der als der für die Transmission der elektromagnetischen Strahlung R geeignetes optisches Element ausgebildeten Deckplatte 20 zu erreichen, ist die Antireflexionsschicht 30 sowohl auf der dem Halbleiterschichtenstapel 10 zugewandten Oberfläche 16 als auch auf der dem Halbleiterschichtenstapel 10 abgewandten Oberfläche 17 der Deckplatte 20 angeordnet. Damit kann erreicht werden, dass für eine vorgegebene Wellenlänge unter einem auf den Normalenvektor N der Oberflächen 16, 17 bezogenen Betrachtungswinkel ALPHA, bei dem die Zunahme des zonalen Lichtflusses der elektromagnetischen Strahlung R ein Maximum aufweist, eine minimale Reflexion erreicht wird. Dies ist besonders vorteilhaft, da so die Minimierung der Reflexion auf beiden Oberflächen 16, 17 der Deckplatte erreicht werden kann.

Die Antireflexionsschicht 30 auf einer oder mehreren der Oberflächen 14, 15, 16, 17 erfolgt durch Aufdampfen einer oder mehrerer dünner Schichten eines Materials, insbesondere eines Metallfluorids oder eines Metalloxids. Das Metall des Metallfluorids und/oder des Metalloxids ist bevorzugt aus der Gruppe aus Hafnium, Zirkon, Aluminium, Titan und Magnesium ausgewählt. Geeignete Materialien sind insbesondere Magnesiumfluorid, Siliziumdioxid, Titandioxid oder Zirkondioxid.

Besonders bevorzugt ist, wenn die Antireflexionsschicht 30 mehrere Schichten aufweist. Dies hat den Vorteil, dass dadurch die Reflexion stark minimiert werden kann. Des Weiteren kann durch Ausbildung der Antireflexionsschicht 30 aus mehreren Schichten eine Reflexionsminderung für mehrere Wellenlängen erreicht werden.

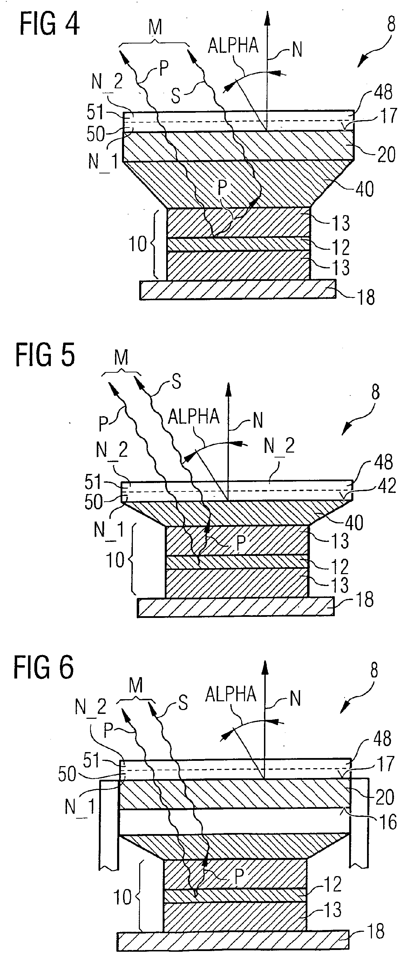

Das strahlungsemittierende Bauelement 8 ist in weiteren Ausführungsformen bevorzugt als Leuchtdiode ausgebildet, die ein Mischlicht, das heißt elektromagnetische Strahlung aus mindestens zwei Wellenlängenbereichen, emittiert (Figuren 4 bis 6). Besonders bevorzugt sind solche strahlungsemittierenden Bauelemente 8 als Weißlichtleuchtdioden ausgebildet.

In den Figuren 4 bis 6 ist das strahlungsemittierende Bauelement 8 mit dem Halbleiterschichtenstapel 10 mit dem aktiven Bereich 12 gezeigt, der zur Emission einer elektromagnetischen Primärstrahlung P ausgebildet ist. Das strahlungsemittierende Bauelement 8 hat eine Konverterschicht 40, die mit dem Halbleiterschichtenstapel 10 mechanisch gekoppelt ist.

Die bei Beaufschlagung mit einem Strom in Durchlassrichtung in dem aktiven Bereich 12 des strahlungsemittierenden Bauelements 8 erzeugte elektromagnetische Primärstrahlung P kann insbesondere ein Spektrum mit Wellenlängen in einem ultravioletten bis infraroten Spektralbereich aufweisen. Insbesondere kann es vorteilhaft sein, wenn das Spektrum zumindest eine für einen Beobachter sichtbare Wellenlänge umfasst. Das Spektrum der elektromagnetischen Strahlung kann vorteilhafterweise auch mehrere Wellenlängen umfassen, sodass bei einem Betrachter ein mischfarbiger Leuchteindruck entstehen kann. Dazu kann es möglich sein, dass das strahlungsemittierende Bauelement 8 selbst elektromagnetische Primärstrahlung P mit mehreren Wellenlängen erzeugen kann oder dass ein Teil der von dem strahlungsemittierenden Bauelement 8 erzeugten elektromagnetische Primärstrahlung P oder die gesamte von dem strahlungsemittierenden Bauelement 8 erzeugte elektromagnetische Primärstrahlung P mit einer ersten Wellenlänge, etwa in einem blauen und/oder grünen Spektralbereich, durch einen Wellenlängenkonversionsstoff in eine elektromagnetische Sekundärstrahlung S einer zweiten Wellenlänge, etwa in einem gelben und/oder roten Spektralbereich, umgewandelt wird. Dazu ist dem aktiven Bereich 12 die Konverterschicht 40 nachgeordnet, die den Wellenlängenkonversionsstoff aufweist. Geeignete Wellenlängenkonversionsstoffe und Schichten mit Wellenlängenkonversionsstoffen sind hinsichtlich ihrem Aufbau und ihrer Funktion dem Fachmann bekannt und werden an dieser Stelle nicht näher erläutert. Ein Teil der elektromagnetischen Primärstrahlung P überlagert sich mit einem Teil der elektromagnetischen Sekundärstrahlung S zu einer elektromagnetischen Mischstrahlung M mit einem resultierenden Farbort. Für Weißlichtleuchtdioden ist die elektromagnetischen Mischstrahlung M weitgehend weißes Licht. Es ist wünschenswert, dass eine derartige Weißlichtleuchtdiode einen in der Fläche möglichst homogenen Farbeindruck vermittelt.

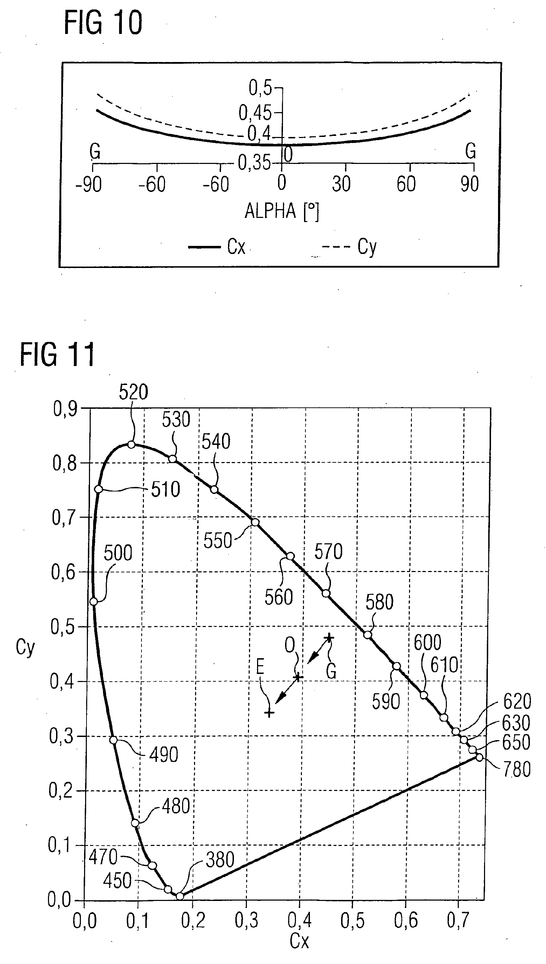

Wie in Figur 10 dargestellt ist, nehmen die Farbortkoordinaten Cₓ und C_{y} der elektromagnetischen Mischstrahlung M mit größer werdendem Betrachtungswinkel ALPHA zu. Dies bedeutet, dass der Anteil von elektromagnetischer Sekundärstrahlung S der zweiten Wellenlänge in dem gelben und/oder roten Spektralbereich in der elektromagnetischen Mischstrahlung M mit größer werdendem Betrachtungswinkel ALPHA zunimmt.

In Figur 11 ist eine CIE-Farbtafel gezeigt mit Farborten beziehungsweise den Farbortkoordinaten Cₓ und C_{y} der elektromagnetischen Mischstrahlung M. Der Farbort G der elektromagnetischen Mischstrahlung M für einen Betrachtungswinkel ALPHA von 90° ist ebenso wie der Farbort O für einen Betrachtungswinkel ALPHA gleich 0° eingetragen. Weiter ist der Unbuntpunkt E, entsprechend reinem weißem Licht, in der CIE-Farbtafel der Figur 11 angegeben.

In den in den Figuren 4 und 6 gezeigten Abwandlungen ist auf der Konverterschicht 40 die Deckplatte 20 angeordnet. Die Deckplatte 20 hat eine von der Konverterschicht 40 abgewandte Oberfläche 17, auf der eine Farbkorrekturschicht 48 angeordnet ist.

Die Farbkorrekturschicht 48 hat mindestens zwei benachbart angeordnete Schichten 50, 51. Die erste Schicht 50 besteht aus einem Material mit einem ersten Brechungsindex N_1, die zweite Schicht 51 aus einem Material mit einem zweiten Brechungsindex N_2. Der erste Brechungsindex N_1 unterscheidet sich von dem zweiten Brechungsindex N_2. Die Schichten 50, 51 sind bezüglich ihrer Brechungsindizes N_1, N_2 und ihrer Dicken derart ausgebildet, dass der resultierende Farbort abhängig von dem Betrachtungswinkel ALPHA einstellbar ist. Durch geeignete Wahl der Brechungsindizes N_1, N_2 und der Dicken der Schichten 50, 51 kann insbesondere erreicht werden, dass der Farbort G für den Betrachtungswinkel ALPHA von 90° beziehungsweise der Farbort O für den Betrachtungswinkel ALPHA gleich 0° näher an den Farbort E heranrücken, wie dies durch Pfeile im CIE-Farbtafeldiagramm der Figur 11 angedeutet ist.

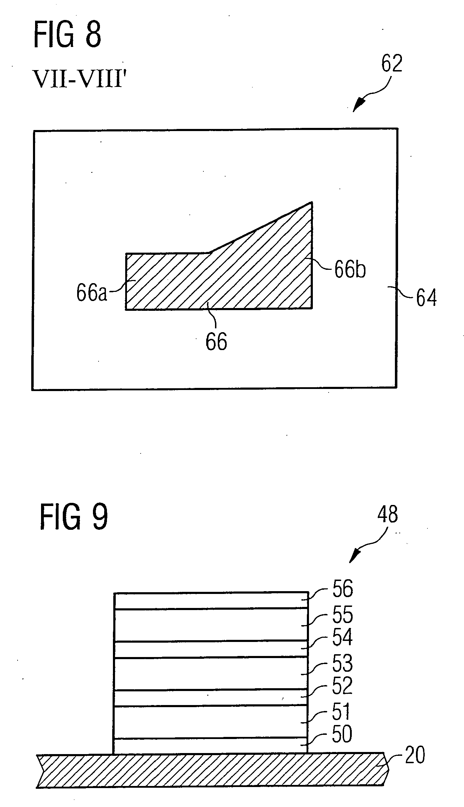

Ist die Farbkorrekturschicht 48 als Schichtenstapel mit einer Vielzahl von Schichten 50, 51, 52, 53, 54, 55, 56 ausgebildet, wie dies in Figur 9 schematisch dargestellt ist, und sind die Schichten 50, 51, 52, 53, 54, 55, 56 so angeordnet, dass die beiden jeweils einer der Schichten benachbarten Schichten Brechungsindizes aufweisen, die beide entweder kleiner oder größer als der Brechungsindex der jeweils einen Schicht sind. Anders ausgedrückt bedeutet dies, dass eine der Schichten der Farbkorrekturschicht 48 jeweils zwischen benachbarten Schichten liegt, die entweder beide einen größeren Brechungsindex oder einen kleineren Brechungsindex aufweisen. Es kann so eine besonders gute Farbkorrektur und damit ein besonders weites Heranrücken der Farborte G, O an den Farbort E erreicht werden.

In Figur 5 ist eine Abwandlung des strahlungsemittierenden Bauelements 8 dargestellt, bei der die Farbkorrekturschicht 48 unmittelbar auf einer Oberfläche 42 der Konverterschicht 40 aufgebracht ist.

Figur 6 zeigt eine Abwandlung des strahlungsemittierenden Bauelements 8, bei der die Deckplatte 20 von der Konverterschicht 40 beabstandet ist. Auf der dem Halbleiterschichtenstapel 10 abgewandten Oberfläche 17 ist die Farbkorrekturschicht 48 angeordnet. Dies hat den Vorteil, dass die Farbkorrekturschicht 48 noch nachträglich auf die Deckplatte 20 aufgebracht werden kann. Die Farbkorrekturschicht 48 kann jedoch auch zusätzlich oder allein auf der dem Halbleiterschichtenstapel 10 zugewandten Oberfläche 16 der Deckplatte 20 angeordnet sein.

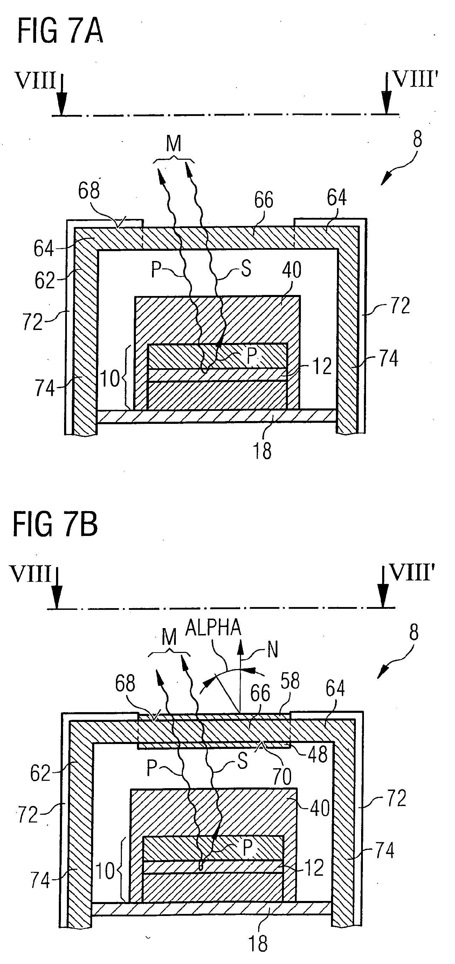

Figuren 7A und 7B zeigen Abwandlungen des strahlungsemittierenden Bauelements 8 mit dem Halbleiterschichtenstapel 10 mit dem aktiven Bereich 12. Der Halbleiterschichtenstapel 10 ist zur Emission elektromagnetischer Primärstrahlung P ausgebildet. Das strahlungsemittierende Bauelement 8 hat die Konverterschicht 40, die mechanisch mit dem Halbleiterschichtenstapel 10 gekoppelt ist. Die Konverterschicht 40 mit einem Leuchtstoff ist ausgebildet zur Konversion eines Teils der elektromagnetischen Primärstrahlung P in die elektromagnetische Sekundärstrahlung S. Ein Teil der elektromagnetischen Primärstrahlung P und die elektromagnetischen Sekundärstrahlung S überlagert sich zu der Mischstrahlung N mit dem resultierenden Farbort.

Das strahlungsemittierende Bauelement 8 hat ein Abdeckelement 62 mit einem ersten Abschnitt 64 und einem zweiten Abschnitt 66. Das Abdeckelement 62 hat eine äußere Oberfläche 68 und eine innere Oberfläche 70. Auf der äußeren Oberfläche 68 des ersten Abschnitts 64 des Abdeckelements 62 ist eine absorbierende oder reflektierende Schicht 72 angeordnet. Die Oberfläche 68, 70 des zweiten Abschnitts 66 des Abdeckelements 62 ist frei von der absorbierenden oder reflektierenden Schicht 72.

Die reflektierende und/oder absorbierende Schicht 72 kann insbesondere auch auf Seitenabschnitten 74 des Abdeckelements 62 angeordnet sein. Damit kann eine Transmission von Licht insbesondere in den Seitenabschnitten 74 des Abdeckelements 62 und in Teilen des Frontbereichs des ersten Abschnitts 64 des Abdeckelements 62 nahe dem zweiten Abschnitt 66 des Abdeckelements 62 (siehe Figur 8) vermieden werden.

Der zweite Abschnitt 66 des Abdeckelements 62, der frei von der absorbierenden und/oder reflektierenden Schicht 72 ist, kann eine geeignete Form aufweisen, wie dies in Figur 8 dargestellt ist. Soll das strahlungsemittierende Bauelement 8 beispielsweise für einen Scheinwerfer eines Kraftfahrzeugs eingesetzt werden, so weist der Lichtkegel an dem Übergang von dem ersten Abschnitt 64 zu dem zweiten Abschnitt 66 einen mehr oder weniger abrupten Dunkel/Hell-Übergang auf. Insbesondere kann der zweite Abschnitt 66 des Abdeckelements 62 zwei Teilabschnitte 66a, 66b aufweisen, deren Haupterstreckungsrichtungen zueinander geneigt sind, derart, dass sie einen Winkel von etwa 150° bis 170° miteinander einschließen. Dies ist insbesondere vorteilhaft, wenn der zweite Abschnitt 66 des Abdeckelements 62 als Shutterelement für einen Scheinwerfer eines Kraftfahrzeugs eingesetzt werden soll, und das Shutterelement vorzugsweise als asymmetrisches Abblendlicht eingesetzt werden soll.

Figur 7B zeigt das strahlungsemittierende Bauelement 8, wobei auf der Oberfläche 68 des zweiten Abschnitts 66 des Abdeckelements 62 eine Antireflexionsschicht 58 angeordnet ist. Die Antireflexionsschicht 58 ist derart ausgebildet, dass das strahlungsemittierende Bauelement 8 für eine vorgegebene Wellenlänge eine minimale Reflexion unter einem auf den Normalenvektor N der Oberfläche 68, 70 bezogenen Betrachtungswinkel ALPHA aufweist, bei dem die Zunahme des zonalen Lichtflusses der elektromagnetischen Mischstrahlung M in etwa ein Maximum aufweist. Die Antireflexionsschicht 58 ist bevorzugt derart ausgebildet, dass sie für die vorgegebene Wellenlänge unter dem Betrachtungswinkel ALPHA zwischen 40 und 50° eine minimale Reflexion aufweist. Besonders bevorzugt ist, wenn die Antireflexionsschicht 58 aus einem Metallfluorid oder einem Metalloxid gebildet ist. Bevorzugt ist das Metall aus der Gruppe aus Hafnium, Zirkon, Aluminium, Titan und Magnesium ausgewählt.

Auf der Oberfläche 70 des zweiten Abschnitts 66 des Abdeckelements 62 ist die Farbkorrekturschicht 48 angeordnet. Die Farbkorrekturschicht 48 hat mindestens zwei benachbart angeordnete Schichten 50, 51. Die erste Schicht 50 besteht aus einem Material mit einem ersten Brechungsindex N_1 und die zweite Schicht 51 aus einem Material mit einem zweiten Brechungsindex N_2. Der erste Brechungsindex N_1 ist von dem zweiten Brechungsindex N_2 verschieden. Damit ist es möglich, die Schichten zur Einstellung des resultierenden Farborts abhängig von dem Betrachtungswinkel ALPHA auszubilden. Insbesondere kann die Farbkorrekturschicht 48 als Schichtenstapel mit einer Vielzahl von Schichten 50, 51, 52, 53, 54, 55, 56 ausgebildet sein (Figur 9).

Die Antireflexionsschicht 58 und die Farbkorrekturschicht 48 sind auf den zwei einander entgegengesetzt angeordneten Oberflächen 68, 70 des zweiten Abschnitts 66 des Abdeckelements 62 angeordnet. Damit kann der zweite Abschnitt 66 des Abdeckelements 62 zur Aufnahme sowohl der Antireflexionsschicht 58 als auch der Farbkorrekturschicht 48 dienen.

## Patentansprüche

1. Strahlungsemittierendes Bauelement (8), das aufweist
- einen Halbleiterschichtenstapel (10) mit einem aktiven Bereich (12), der zur Emission elektromagnetischer Strahlung (R) ausgebildet ist, und
- mindestens eine Oberfläche (14, 15, 16, 17) des Halbleiterschichtenstapels (10) oder eines zur Transmission der elektromagnetischen Strahlung (R) ausgebildeten optischen Elements (18, 20), wobei die Oberfläche (14, 15, 16, 17) einen Normalenvektor (N) hat,
wobei
auf der mindestens einen Oberfläche (14, 15, 16, 17) des Halbleiterschichtenstapels (10) oder des optischen Elements (18, 20), durch die die elektromagnetische Strahlung (R) hindurch tritt, eine Antireflexionsschicht (30) angeordnet und derart ausgebildet ist, dass sie für eine vorgegebene Wellenlänge, welche eine Emissionswellenlänge des Halbleiterschichtenstapels ist, eine minimale Reflexion unter einem auf den Normalenvektor (N) der Oberfläche (14, 15, 16, 17) bezogenen Betrachtungswinkel (ALPHA) aufweist,
**dadurch gekennzeichnet,**
**dass** die Zunahme der über einem Raumwinkelbereich zwischen 0° und dem Betrachtungswinkel integrierten Lichtfluss-Winkelverteilung der elektromagnetischen Strahlung unter einem Betrachtungswinkel zwischen 30° und 60° ein Maximum aufweist und die Antireflexionsschicht (30) derart ausgebildet ist, dass sie für die vorgegebene Wellenlänge die minimale Reflexion unter dem auf den Normalenvektor (N) bezogenen Betrachtungswinkel (ALPHA) zwischen 30° und 60° aufweist.

2. Strahlungsemittierendes Bauelement (8) nach Anspruch 1, wobei die Antireflexionsschicht (30) derart ausgebildet ist, dass sie für die vorgegebene Wellenlänge die minimale Reflexion unter dem auf den Normalenvektor (N) bezogenen Betrachtungswinkel (ALPHA) zwischen 40° und 50° aufweist.

3. Strahlungsemittierendes Bauelement (8) nach einem der vorhergehenden Ansprüche, mit einem Substrat (18), auf dem der Halbleiterschichtenstapel (10) angeordnet ist, und das eine von dem Halbleiterschichtenstapel (10) abgewandte Oberfläche (15) hat, auf der die Antireflexionsschicht (30) angeordnet ist.

4. Strahlungsemittierendes Bauelement (8) nach einem der vorhergehenden Ansprüche, wobei das strahlungsemittierende Bauelement (8) eine Deckplatte (20) aufweist, die von dem Halbleiterschichtenstapel (10) beabstandet ist, wobei die Deckplatte (20) eine dem Halbleiterschichtenstapel (10) zugewandte Oberfläche (16) und eine von dem Halbleiterschichtenstapel (10) abgewandte Oberfläche (17) aufweist, und die Antireflexionsschicht (30) auf mindestens einer der Oberflächen (16, 17) der Deckplatte (20) angeordnet ist.

5. Strahlungsemittierendes Bauelement (8) nach einem der Ansprüche 3 oder 4, wobei das Substrat (18) ein Material umfasst, das aus der Gruppe von Glas, Quarz und Kunststoff ausgewählt ist.

## Claims

1. Radiation-emitting component (8) comprising
- a semiconductor layer stack (10) having an active region (12) embodied for the emission of electromagnetic radiation (R), and
- at least one surface (14, 15, 16, 17) of the semiconductor layer stack (10) or of an optical element (18, 20) embodied for the transmission of the electromagnetic radiation (R) wherein the surface 14, 15, 16, 17) has a normal vector (N),
wherein
on the at least one surface (14, 15, 16, 17) of the semiconductor layer stack (10) or of the optical element (18, 20) through which the electromagnetic radiation (R) passes, an antireflection layer (30) is arranged and embodied in such a way that, for a predetermined wavelength, which is an emission wavelength of the semiconductor layer stack, it has a minimum reflection at a viewing angle (ALPHA) relative to the normal vector (N) of the surface (14, 15, 16, 17), **characterized in that** the increase in the luminous flux angle distribution of the electromagnetic radiation, said distribution being integrated over a solid angle range of between 0º and the viewing angle, has a maximum at a viewing angle of between 30º and 60º, and the antireflection layer (30) is embodied in such a way that, for the predetermined wavelength, it has the minimum reflection at the viewing angle (ALPHA) relative to the normal vector (N) of between 30° and 60°.

2. Radiation-emitting component (8) according to Claim 1, wherein the antireflection layer (30) is embodied in such a way that, for the predetermined wavelength, it has the minimum reflection at the viewing angle (ALPHA) relative to the normal vector (N) of between 40º and 50º.

3. Radiation-emitting component (8) according to any of the preceding claims, comprising a substrate (18) on which the semiconductor layer stack (10) is arranged, and which has a surface (15) which is remote from the semiconductor layer stack (10) and on which the antireflection layer (30) is arranged.

4. Radiation-emitting component (8) according to any of the preceding claims, wherein the radiation-emitting component (8) has a cover plate (20) spaced apart from the semiconductor layer stack (10) wherein the cover plate (20) has a surface (16) facing the semiconductor layer stack (10) and a surface (17) remote from the semiconductor layer stack (10) and the antireflection layer (30) is arranged on at least one of the surfaces (16, 17) of the cover plate (20).

5. Radiation-emitting component (8) according to either of Claims 3 and 4, wherein the substrate (18) comprises a material selected from the group of glass, quartz and plastic.

## Revendications

1. Composant (8) émettant un rayonnement, le composant présentant :
un empilement (10) de couches semi-conductrices présentant une partie active (12) configurée pour émettre un rayonnement électromagnétique (R) et
au moins une surface (14, 15, 16, 17) de l'empilement (10) de couches semi-conductrices ou d'un élément optique (18, 20) configuré pour transmettre le rayonnement électromagnétique. (R), la surface (14, 15, 16, 17) présentant un vecteur normal (N),
une couche anti-réfléchissante (30) étant disposée sur la ou les surfaces (14, 15, 16, 17) de l'empilement (10) de couches semi-conductrices ou de l'élément optique (18, 20) traversé par le rayonnement électromagnétique (R) et étant configurée de manière à présenter pour une longueur d'onde prédéterminée qui est la longueur d'onde d'émission de l'empilement de couches semi-conductrices une réflexion minimale sous un angle d'observation (ALPHA) par rapport au vecteur normal (N) à la surface (14, 15, 16, 17),
**caractérisé en ce que**
l'augmentation de la distribution angulaire du flux de lumière intégré sur une plage d'angle solide comprise entre 0° et l'angle d'observation présente un maximum pour un angle d'observation compris entre 30° et 60° et
**en ce que** la couche anti-réfléchissante (30) est configurée de telle sorte qu'elle présente une réflexion minimale pour la longueur d'onde prédéterminée à un angle d'observation (ALPHA), rapporté au vecteur normal (N), compris entre 30° et 60°.

2. Composant (8) émettant un rayonnement selon la revendication 1, dans lequel la couche anti-réfléchissante (30) est configurée de telle sorte qu'elle présente une réflexion minimale pour la longueur d'onde prédéterminée à un angle d'observation (ALPHA) par rapport au vecteur normal (N) compris entre 40° et 50°.

3. Composant (8) émettant un rayonnement selon l'une des revendications précédentes, présentant un substrat (18) sur lequel l'empilement (10) de couches semi-conductrices est disposé, le substrat présentant une surface (15) non tournée vers l'empilement (10) de couches semi-conductrices et sur laquelle la couche anti-réfléchissante (30) est disposée.

4. Composant (8) émettant un rayonnement selon l'une des revendications précédentes, dans lequel le composant (8) émetteur de rayonnement présente une plaque de recouvrement (20) maintenue à distance de l'empilement (10) de couches semi-conductrices, la plaque de recouvrement (20) présentant une surface (16) tournée vers l'empilement (10) de couches semi-conductrices et une surface (17) non tournée vers l'empilement (10) de couches semi-conductrices, la couche anti-réfléchissante (30) étant disposée sur au moins l'une des surfaces (16, 17) de la plaque de recouvrement (20).

5. Composant (8) émettant un rayonnement selon l'une des revendications 3 ou 4, dans lequel le substrat (18) comporte un matériau sélectionné dans l'ensemble constitué du verre, du quartz et des matières synthétiques.
